# EUROPEAN PATENT SPECIFICATION

(11) **EP 0 392 536 B1**
(45) Date of publication and mention of the grant of the patent: **02.07.1997**
(21) Application number: 90107033.4
(22) Date of filing: 12.04.1990
(51) Int. Cl.: H01L 27/148, H01L 21/82, H01L 27/105

(54) **Semiconductor device having CCD and its peripheral bipolar transistors and method of manufacturing the same**
Halbleiteranordnung mit CCD und dessen peripheren Bipolartransistoren und Verfahren zu dessen Herstellung
Dispositif semi-conducteur comprenant un CCD et ses transistors bipolaires périphériques et son procédé de fabrication

(30) Priority: 13.04.1989 JP 93607/89
(43) Date of publication of application: 17.10.1990
(73) Proprietor: KABUSHIKI KAISHA TOSHIBA, Kawasaki-shi, Kanagawa-ken 210 (JP)
(72) Inventor: Kihara, Kazuo, c/o Intellectual Property Division, Tokyo 105 (JP); Taguchi, Minoru, c/o Intellectual Property Div., Tokyo 105 (JP)
(74) Representative: Lehn, Werner, Dipl.-Ing.

(56) References cited:
- EP-A- 0 067 661
- US-A- 4 034 199
- US-A- 4 152 715
- US-A- 4 253 168
- PATENT ABSTRACTS OF JAPAN, vol. 9, no. 291 (E-359)[2014], 19th November 1985; & JP-A-60 132 367
- I. RUGE : "Halbleiter-Technologie", Springer-Verlag, Berlin 1984, pp. 359-363

## Description

The present invention relates to a semiconductor device in which a charge transfer device and a bipolar transistor are formed on a single chip, in particular to a semiconductor device comprising a semiconductor chip, a charge transfer device section formed in the semiconductor chip and driven by predetermined clocks, a bipolar transistor section formed adjacent to the charge transfer device section in the semiconductor chip, a prevention means for preventing charge which is generated in said semiconductor chip owing to the clocks of the charge transfer device section from being transferred to the bipolar transistor section, and a first MOS transistor section. The present invention also relates to a method of manufacturing a semiconductor device including a charge transfer device.

In general, a CCD, which is one type of charge transfer devices, is formed on a single chip in combination with n-channel type MOSFETs. The n-channel type MOSFETs, combined with the CCD, constitute a CCD delay line, a CCD drive circuit, a sample/hold circuit, an output circuit, a clock drive circuit, etc. The power source voltage employed in the MOSFET is 12 V or 9 V. Recently, in accordance with a requirement for the reduction in power consumption, a power source voltage of 5 V is employed in order to use MOSFETs in the form of CMOS's, and to match the power source voltage for the FET with that for a bipolar IC formed in another chip.

However, in the case where the power source voltage of 5 V is employed, as compared to the conventionally employed power source voltage of 12 V or 9 V, the input/output linearity of a sample/hold circuit and an operational amplifier such as an output circuit, which are constituted by MOSFETs, is degraded. Thus, the yield of wafers lowers owing to poor linearity of input/output characteristics in a wafer test.

Also, the only function of a CCD delay line using a CCD is to delay an input signal. The circuit for performing delay processing for this signal is, in general, a bipolar IC formed on a separate chip.

For example, when MOSFETs used in a sample/hold circuit and/or an operational amplifier such as an output circuit are replaced with bipolar transistors which have excellent input/output linearity and operate at high speed at low voltage, and if these bipolar transistors and CCDs are formed on a single chip, the input/ output linearity can be improved, the yield is enhanced, and high-performance is achieved. Further, if bipolar transistors for processing signals from CCDs and CCDs are formed on a single chip, such advantages as reduction in size and manufacturing cost, increase in the number of functions, and simplification in system can be brought about.

However, if CCDs are used along with bipolar transistors on a single chip, charge of transfer clocks employed for transferring charge of CCDs may leak to a base region or the like in a bipolar transistor. Because of this, it is difficult to use CCDs along with bipolar transistors on a single chip. In other words, the circuit operation of the bipolar transistor is considerably adversely affected by the leak of transfer clocks, the characteristics of the bipolar transistor are degraded, and the reliability of the product is lowered.

One example for the simultaneous use of a charge coupled device and bipolar transistors on a single semiconductor device is described in US-A-4 253 168 relating to a CCD signal processor. In particular, there is described an apparatus for forming one or more sonar beams in response to acoustic energy received a transducer array. To minimize volume utilization a plurality of charge coupled devices is formed on an integrated circuit chip with the charge coupled devices being of progressively smaller length. Half of the charge coupled device array is folded over to match the other half so that each of the charge coupled devices has an opposing charge coupled device with both charge couple devices propagating a signal toward a common output diode. In order to isolate different sections of the output circuit of this semiconductor device it is proposed to incorporate a polysilicon structure that acts as a field shield and that is electrically tied to the substrate.

Further in US-A-4 034 199 there is described a programmable analogue transversal filter for processing analogue signals and comprising charge coupled devices and a plurality of NMOS memory devices. The charge coupled devices receive a series of discrete analogue signals that are to be delayed by increasing periods and propagated to the outputs of the charge couple devices. The NMOS memory devices are coupled to the tabs of the charge couple devices and programmed so that the output of each charge couple device tab is multiplied by a particular weighting factor. Every weighting factor is set by varying the threshold voltage of the corresponding NMOS device. For the isolation of support circuitry in the system it is proposed to diffuse a P-type region around the respective devices that penetrate the epitaxial layer underneath thereof.

In EP-A-0 067 661 particular reference is made to a BICMOS device that comprises a bipolar transistor simultaneously with complementary MOS transistors. Further there is described a manufacturing method that allows to implement this semiconductor device with a minimum number of processing steps and with a high packing density. Since the MCS transistors are complementary MOS transistors they do not substantially cause a problem relating to the later phenomenon.

Finally, in I. Ruge: "Halbleiter-Technologie", Springer-Verlag, Berlin 1984, pages 359 - 363, there is described an approach wherein buried layers of the N+-type together with two deep diffusions of the N-type are used for the electrical isolation of an NPN-transistor.

In view of the above the object of the invention is to provide a semiconductor device having a charge transfer device together with bipolar and MOSFET-transistors on a single chip without lowering the reliability of the finished device.

To achieve this object the semiconductor device outlined above is realized so that the first MOS transistor section is provided between the charge transfer device and the bipolar transistor, a second MOS transistor section is provided adjacent to the charge transfer device section at a side thereof lying opposite to the first MOS trnasistor section, and the prevention means is formed in the semiconductor chip adjacent to the first MOS transistor section and comprises wall regions, without a wall region adjacent to the second MOS transistor section.

Further, to achieve the object there is proposed a method of manufacturing a semiconductor device including a charge transfer device, comprising the steps of forming N+-type buried layers in a charge transfer device formation section, an NPN-type bipolar transistor section, a first P-channel type MOSFET formation section, and a second P-channel type MOSFET formation section on a P-type semiconductor substrate, forming a P-type epitaxial layer on said P-type semiconductor substrate in which said N+-type buried layers have been formed, forming at least three N-type well regions in said P-type epitaxial layer such that said N-type well regions reach said N+-type buried layers formed in said NPN-type bipolar transistor formation section, said first P-channel type MOSFET formation section, and said second P-channel type MOSFET formation section, forming an N+-type region in said N-type well region of said NPN-type bipolar transistor formation section reaching said N-type buried layer and forming a second N+-type region in said P-type epitaxial layer of said charge transfer device formation section, so that said second N+-type region constitute wall regions of a charge transfer prevention means lying adjacent to said first P-channel type MOSFET formation section without a wall region adjacent to said second P-channel type MOSFET formation section, and forming an NPN-type bipolar transistor block and a P-channel type MOSFET block in said N-type well regions of said NPN-type bipolar transistor section and said first P-channel type MOSFET formation section, respectively, forming a N-channel type MOSFET block in said P-type epitaxial layer of said first P-channel type MOSFET formation section, and forming a charge transfer device block in a region of said charge transfer device formation section in said P-type epitaxial layer being partly surrounded by said charge transfer prevention means.

Thus, in the semiconductor device according to the present invention since the charge transfer device block is partly surrounded by the N+-type region and the N+-type buried layer leaked charge of clocks from the charge transfer device is absorbed by the N+-type region and the N+-type buried layer. Therefore even if the charge transfer device and the bipolar transistors are formed on a single chip the bipolar transistor is not adversely affected by the clock leak.

Since the MOS transistor section that is less influenced by clock leak than the bipolar transistor section is interposed between the charge transfer device section and the bipolar transistor section a large distance can be kept between the charge transfer device section and the bipolar transistor section so that the thickness of the side wall necessary for suppressing clock leak to the bipolar transistor section can be reduced and the integration density of the resulting semiconductor device is reduced. In addition, such a side wall is only provided on the side of the charge transfer device section that faces the bipolar transistor section whereas the side lying remote therefrom is omitted to further increase the integration density.

The improved decoupling of the charge transfer device section and the bipolar transistor section allows to realize a sample/hold circuit and/or an operational amplifier such as an output circuit which has conventionally been constituted by MOSFET transistors by bipolar transistors. Thus, the input/output linearity of the amplifier is enhanced, the yield of the semiconductor devices including charge transfer devices is increased and the performance of the device is improved without lowering the reliability of the product. In particular, even if a power source voltage of the bipolar operational amplifier is set to 5 Volts the linearity of the bipolar operational amplifier is not degraded.

Finally, bipolar devices for the generation of the processing of the charge transfer device which are conventionally. formed on a separate integrated circuit chip can be integrated into the semiconductor device. Thus, a circuit board for using the device of the present invention allows a decrease in space, a decrease in manufacturing costs, an increase in number of functions and an overall simplification of the whole system. In addition, since wiring is not required for the ccnnection of separate chips, the yield further increases and in relation thereto also the reliability since the structure of the hardware of the system is simplified.

This invention can be more fully understood from the following detailed description when taken in conjunction with the accompanying drawings, in which:
Figs. 1A to 1N are cross-sectional views for illustrating the process of manufacturing a semiconductor device, in which
Fig. 1A shows the state wherein three N⁺-type buried layers are formed in a P-type substrate, and a P-type epitaxial layer is formed over the three N⁺-type buried layers;
Fig. 1B shows the state wherein N-type wells are formed on the two N⁺-type buried layers (on the right and left in the figure), and a silicon oxide film is formed on the resultant structure;
Fig. 1C shows the state wherein an N⁺-type wall is formed on a peripheral region of the middle N⁺-type buried layer;
Fig. 1D shows the state wherein a double layer consisting of an oxide layer and a nitride layer is formed on the device;
Fig. 1E shows the state wherein a P-inversion preventing layer is formed around the walls of the right and left N-type wells and the middle N⁺-type well;
Fig. 1F shows the state wherein field oxide films are formed on the peripheral portions of the right and left N-type wells and on the wall of the middle N⁺-type well;
Fig. 1G shows the state wherein gate oxide films are formed between the individual field oxide films;
Fig. 1H shows the state wherein a polysilicon layer are formed on the field oxide films and the gate oxide films;
Fig. 1I shows the state wherein the polysilicon layer is patterned and thereby gate electrodes are formed, and also a P-type base region is formed in the N-type well;
Fig. 1J shows the state wherein the oxide film is removed, excepting for predetermined regions;
Fig. 1K shows the state wherein a second gate electrode film is formed;
Fig. 1L shows the state wherein a second polysilicon layer is formed, and an N⁺-type emitter region is formed on the P-type base region in the right N-type well;
Fig. 1M shows the state wherein a PMOS transistor is formed in the left N-type well region, and an insulating film is formed on the uppermost layer of the chip; and
Fig. 1N is a cross-sectional view of a semiconductor device which has been finished by providing the structure shown in Fig. 1M with predetermined contacts;
Fig. 2 is a top view of the structure shown in Fig. 1N, wherein a bipolar transistor block is arranged on the right of a CCD block surrounded by an N⁺-type wall;
Fig. 3 shows a modification of the structure shown in Fig. 1N, wherein MOS transistor blocks are interposed between the CCD block and the bipolar transistor block;
Fig. 4 is a top view of the structure shown in Fig. 3;
Fig. 5 shows a modification of the structure according to the invention shown in Fig. 3, wherein the N⁺-type wall on the left of the CCD block is removed and, instead, a MOS transistor block is arranged; and
Fig. 6 is a top view of the structure shown in Fig. 5.

A semiconductor device having a charge transfer device and a method of manufacturing the same, according to an embodiment of the present invention, will now be described with reference to the accompanying drawings.

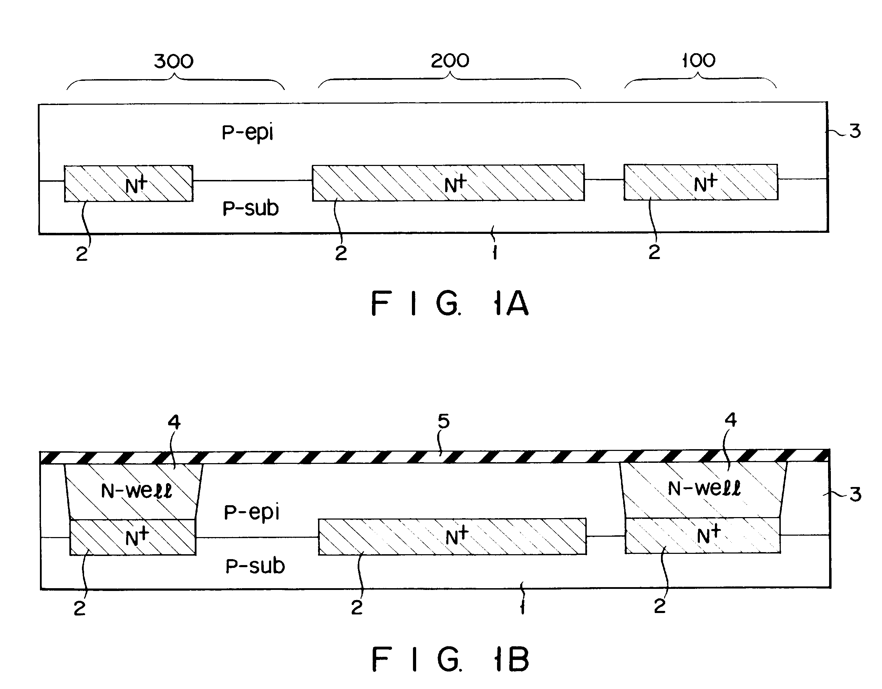

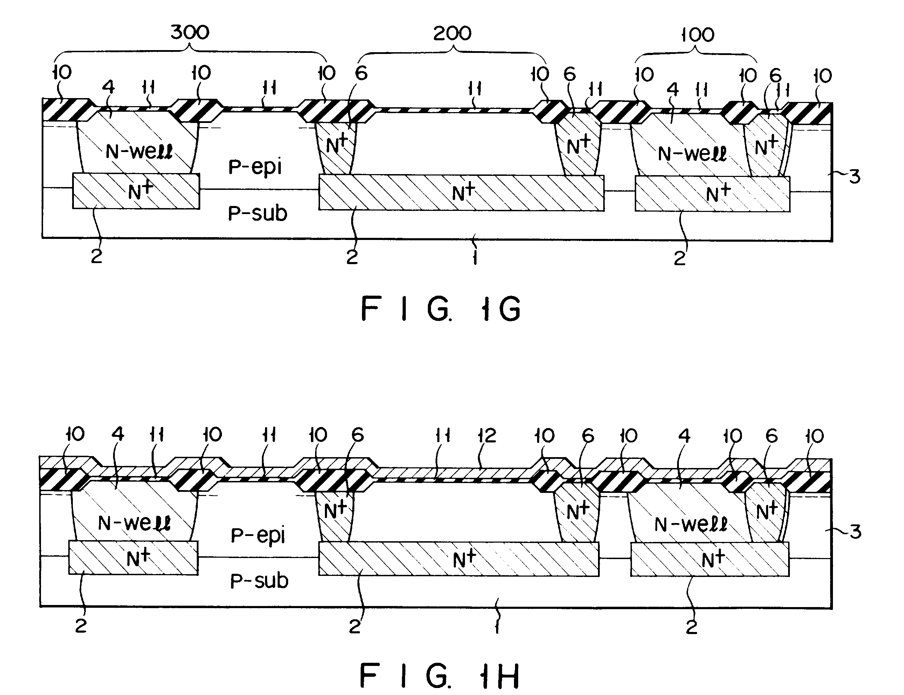

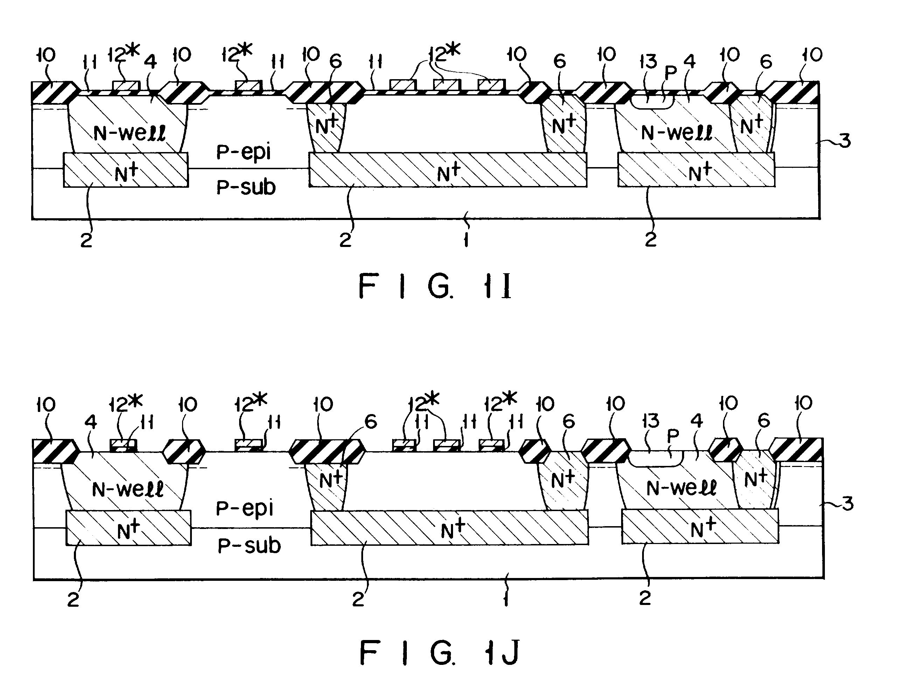

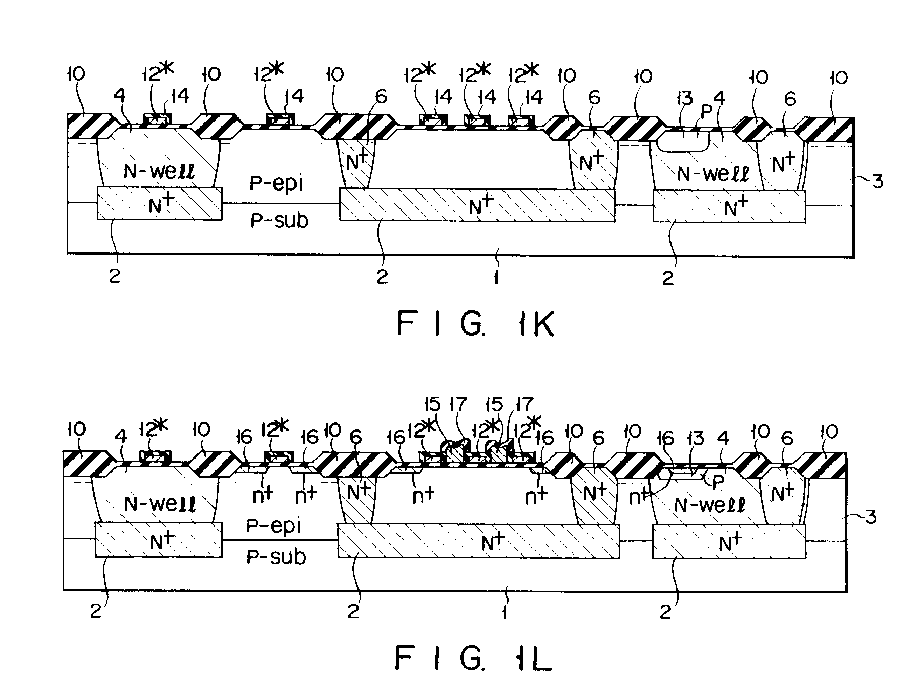

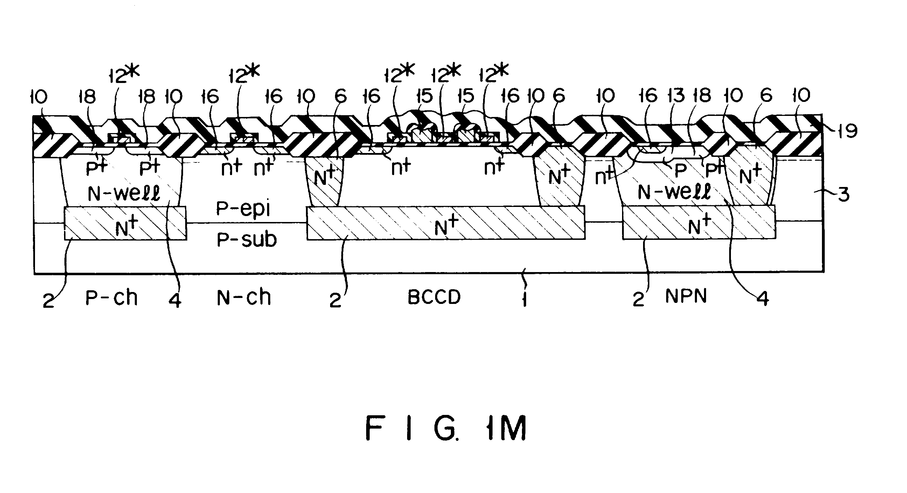

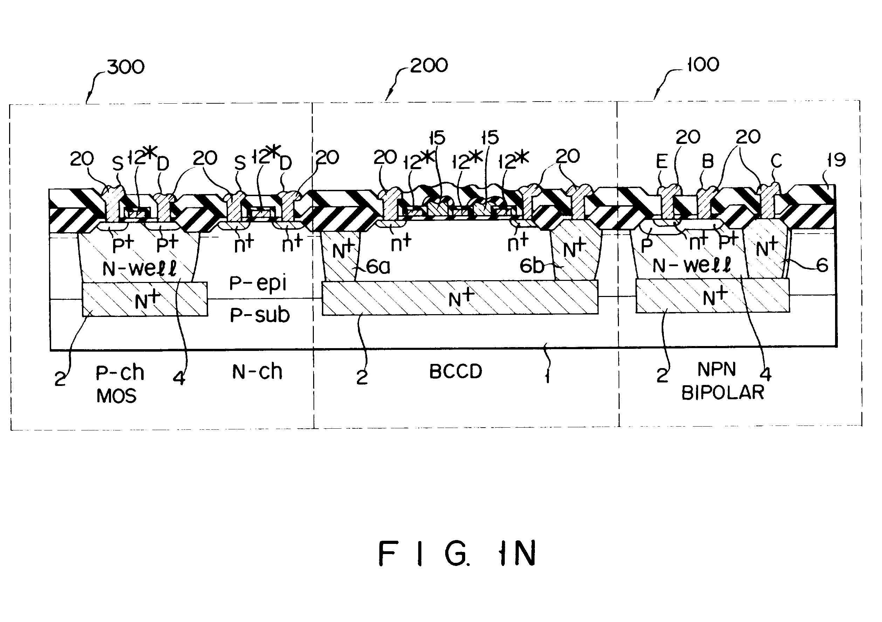

Figs. 1A to 1N are cross-sectional views for illustrating the method of manufacturing a semiconductor device with a charge transfer device, in the order of the manufacturing steps.

In Fig. 1A, an oxide film (not shown) is formed on a P-type semiconductor substrate 1, before an epitaxial layer 3 is formed. The oxide film is patterned by means of photoetching using a photoresist, thereby to form a pattern for high-concentration N⁺-type buried layers. With this pattern used as a mask, an N-type impurity or arsenic is ion-implanted, thus forming high-concentration N⁺-type buried layers 2 in a bipolar transistor formation region 100, a CCD formation region 200, and a MOS transistor formation region 300. Then, a P-type epitaxial layer 3 is formed over the surface of the substrate by means of a CVD method. The impurity concentration of the P-type epitaxial layer 3 is set to an optimal value for the characteristics of a CCD to be manufactured.

As shown in Fig. 1B, the P-type epitaxial layer 3 is subjected to a heat treatment in an oxygen atmosphere at a temperature of 950°C by means of a thermal oxidizing method, whereby an oxide layer 5 having a thickness of 50 nm. Subsequently, a photoresist (not shown) is coated, and a pattern for an N-type well region is formed on the photoresist by means of photoetching. With the photoresist having the pattern being used, an N-type impurity or phosphorus is ion-implanted under the conditions of an acceleration voltage of 100 KeV and a dose amount of 2.0 × 10¹² cm⁻². The ion-implanted phosphorus is subjected to a heat treatment in a nitrogen atmosphere at a temperature of 1100°C for 5 hours, thus forming an N-type well region 4 such that the region 4 reaches the high-concentration N⁺-type buried layer 2.

A photoresist (not shown) is coated on the epitaxial layer 3, and a mask pattern is formed on the photoresist by means of photoetching. This mask pattern is used to form a collector take-out region of a npn-type bipolar transistor, and a high-concentration N⁺-type region situated around a BCCD (Bulk CCD, serving as a charge transfer device) formation region. With the photoresist having the pattern being used, an N-type impurity or phosphorus is ion-implanted under the conditions of an acceleration voltage of 50 KeV and a dose amount of 5.0 × 10¹⁵ cm⁻². Then, a CVD oxide film (serving as a cap for preventing out-diffusion) is formed by means of a CVD method, such that the CVD oxide film has a thickness of 400 nm. The ion-implanted phosphorus is subjected to a heat treatment in a nitrogen atmosphere at a temperature of 1100°C and for 30 minutes. Thereafter, the surface oxide film is removed. As shown in Fig. 1C, a high-concentration N⁺-type region 6 is formed such that it reaches the high-concentration N⁺-type buried layer 2.

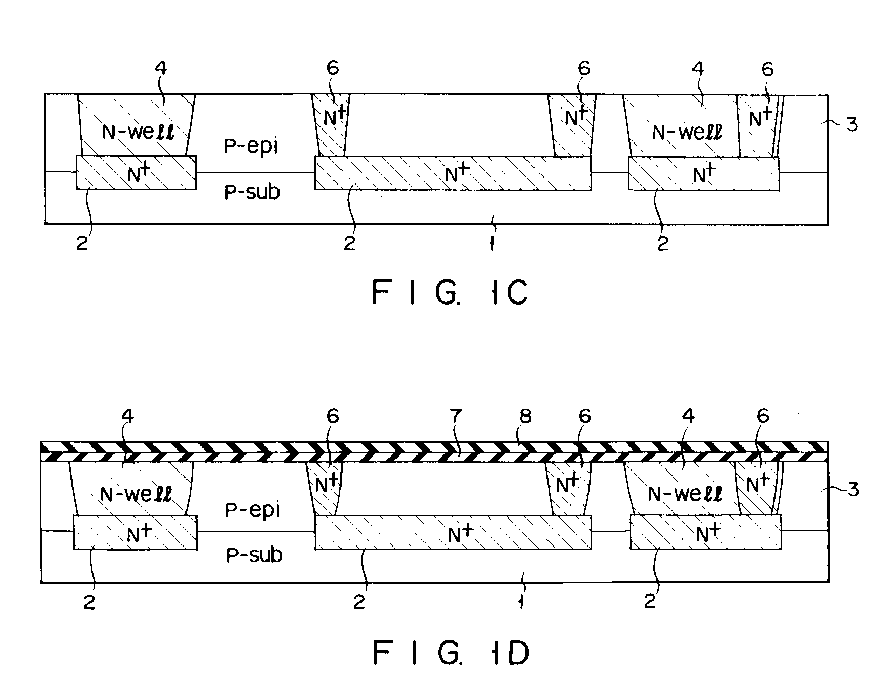

The epitaxial layer 3 is subjected to a thermal oxidizing process in an atmosphere of a mixture of hydrogen and oxygen at a temperature of 950°C. Thus, as shown in Fig. 1D, lower oxide film 7 having a thickness of 90 nm is formed. A nitride film 8 having a thickness of 200 nm is formed by a CVD method over the oxide film 7.

A photoresist (not shown) is coated over the resultant structure, and an element-separation pattern is formed on the photoresist by means of photoetching. Then, as shown in Fig. 1E, the photoresist having the element-separation pattern is used as a mask, and the nitride film 8 is partially removed. Subsequently, a photoresist (not shown) is coated over the resultant structure, and a P-type inversion preventing layer pattern is formed on this photoresist by means of photoetching. With the photoresist having the P-type inversion preventing layer being used as a mask, a P-type impurity or boron is ion-implanted under the conditions of an acceleration voltage of 50 KeV and a dose amount of 8.0 × 10¹³ cm⁻², thereby forming a P-inversion preventing layer 9. The photoresist used for forming the P-type inversion preventing layer pattern is removed, and another photoresist is coated. Then, an N-type inversion preventing layer pattern is formed by means of photoetching on the newly formed photoresist. With the pattern used as a mask, an N-type impurity or phosphor is ion-implanted under the conditions of an acceleration voltage of 100 KeV and a dose amount of 5.0 × 10¹² cm⁻², and N-type inversion preventing layers (not shown) are formed in the individual N-type wells 4.

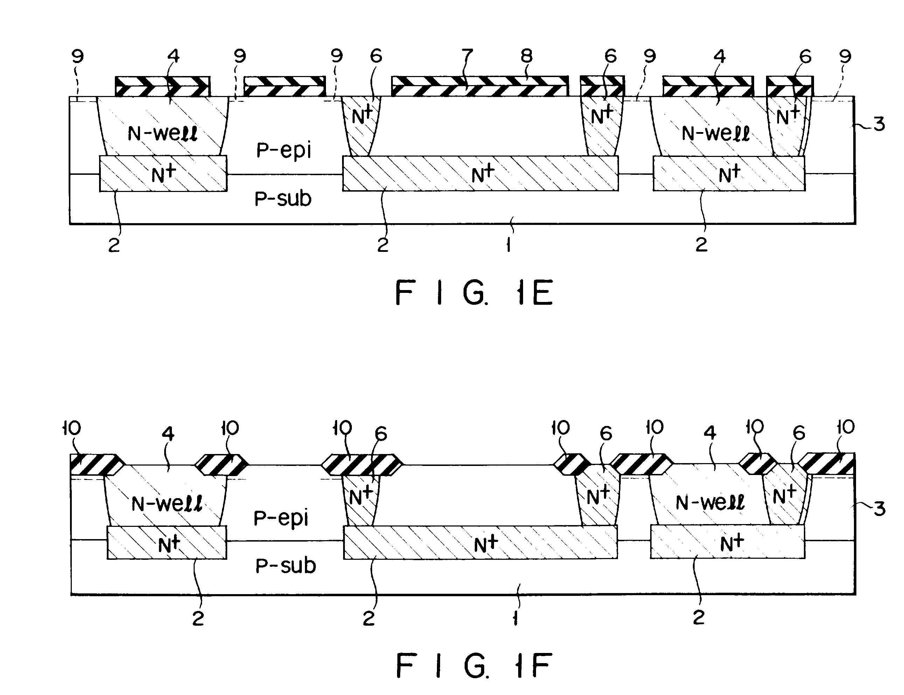

The device shown in Fig. 1E is subjected to a thermal oxidizing process in an atmosphere of a mixture of hydrogen and oxygen at a temperature of 1000°C, with use of a nitride film 8 having resistance to oxidization. As shown in Fig. 1F, a field oxide film 10 having a thickness of 950 nm, which serves as an element-separation region, is formed. Subsequently, the nitride film 8 and the lower oxide film 7 are removed by a CDE method using NH₄F.

The resultant structure is subjected to a heat treatment in an atmosphere of oxygen and hydrochloric acid at a temperature of 950°C. Thus, a first gate oxide film 11 having a thickness of 67 nm is formed over the surface of the epitaxial layer 3.

A prescribed channel doping is carried out in the CCD formation region 200 and the formation region 300 for the N-channel type MOSFET and the P-channel type MOSFET.

In the subsequent step shown in Fig. 1H, a first polysilicon layer 12 having a thickness of 390 nm is formed by means of a CVD method over the entire surface of the device. The first polysilicon layer 12 is rendered conductive by subjecting the same to a heat treatment in an atmosphere of an N-type impurity or POCℓ₃ at a temperature of 1000°C.

Then, a photoresist (not shown) is coated, and a gate pattern for a MOSFET using the first polysilicon layer 12, and a first gate pattern of a CCD are formed on the photoresist by means of photoetching. With the photoresist having the gate patterns being used as a mask, a gate 12* of the MOSFET and a first gate 12* of the CCD are formed by patterning, as shown in Fig. 1I. The photoresist having the gate patterns is removed, and another photoresist (not shown) is coated. A P-type internal base region pattern of an npn-type bipolar transistor is formed on the newly coated photoresist by means of photoetching. By using the photoresist having the P-type internal base region pattern as a mask P-type impurity or boron is ion-implanted under the conditions of an acceleration voltage of 40 KeV and a dose amount of 3.0 × 10¹⁴ cm⁻², thereby forming a P-type internal base region 13. The resultant structure is subjected to a heat treatment in a nitrogen atmosphere at a temperature of 900°C for 30 minutes, thus activating the ion-implanted impurity.

Subsequently, unnecessary oxide film or the like on the epitaxial layer 3 is removed by means of wet etching using NH₄F, and the epitaxial layer 3 is exposed, as shown in Fig. 1J.

The epitaxial layer 3 is subjected to a thermal oxidizing process in an atmosphere of a mixture of oxygen and hydrogen at a temperature of 950°C, whereby a second gate oxide film 14 having a thickness of 67 nm is formed over the entire surface of the epitaxial layer 3, as shown in Fig. 1K.

Then, as shown in Fig. 1L, a second polysilicon layer 15 having a thickness of 390 nm is formed by means of a CVD method on the entire surface of the device. The second polysilicon layer 15 is treated and made conductive in an atmosphere of N-type impurity or POCℓ₃ at a temperature of 1000°C. A photoresist (not shown) is coated, and a second gate pattern for a second gate of a CCD, which is formed by the second polysilicon layer 15, is formed on the photoresist by means of photoetching. With the photoresist having the second gate pattern for the CCD used as a block, a second gate 15 (polysilicon) of the CCD is formed by patterning. The photoresist having the second gate pattern for the CCD is removed, and another photoresist (not shown) is coated. high-concentration N⁺-type region pattern, for forming a high-concentration N⁺-type emitter region of an NPN-type bipolar transistor, a source/drain region of an N-channel type MOSFET, and portions of a CCD in which charge is injected and accumulated, is formed by means of photoetching on the newly coated photoresist. Using the photoresist having the high-concentration N⁺-type region pattern as a mask, an N-type impurity or arsenic is ion-implanted under the conditions of an acceleration voltage of 40 KeV and a dose amount of 5.0 × 10¹⁵ cm⁻², thereby forming a high-concentration N⁺-type impurity region 16. By subjecting the resultant body to a thermal oxidizing process in an oxygen atmosphere at a temperature of 1000°C for 20 minutes, an oxide film 17 is formed on the surface of the second gate 15 of the CCD.

Subsequently, a photoresist (not shown) is coated, and a high-concentration P⁺-type region pattern for forming an external base region of the NPN-type bipolar transistor and a source/drain region of the P-channel MOSFET is formed by means of photoetching on the photoresist. Using the photoresist having the high-concentration P⁺-type region pattern as a mask, a P-type impurity or boron is ion-implanted under the conditions of an acceleration voltage of 40 KeV and a dose amount of 2.0 × 10¹⁵ cm⁻², thereby forming a high-concentration P⁺-type impurity region 18, as shown in Fig. 1M. An interlayer insulating film 19, having a triple structure consisting of a CVD oxide film with a thickness of 300 nm, a BPSG film with a thickness of 900 nm and a PSG film with a thickness of 250 nm, is formed by means of a CVD method over the entire surface of the device. The device is subjected to a heat treatment in a POCℓ₃ atmosphere at a temperature of 950°C, thereby achieving phosphorus gettering. At this time, the emitter region 16 of the NPN-type bipolar transistor is diffused.

Then, a photoresist (not shown) is coated, and a predetermined contact hole pattern is formed on the photoresist by means of photoetching. Using the photoresist having the contact hole pattern as a mask, a contact hole is formed through the interlayer insulating film 19 by means of a CDE method and an RIE method, as shown in Fig. 1N. An aluminum layer 20 is formed on the entire surface of the device by means of sputtering. Subsequently, a photoresist (not shown) is coated, and a predetermined electrode pattern is formed on the photoresist by means of photoetching. Using the photoresist having the electrode pattern as a block, the aluminum layer 20 is patterned to form an aluminum electrode 20. In Fig. 1N, symbol S denotes a source of a MOSFET, D a drain thereof, E an emitter of an NPN-type bipolar transistor, B a base thereof, and C a collector thereof. In a subsequent step, a surface protection film is formed over the entire surface of the device, and predetermined wiring is formed, whereby the manufacture of a semiconductor device having the bipolar transistor region 100, CCD region 200 and MOS region 300 is finished.

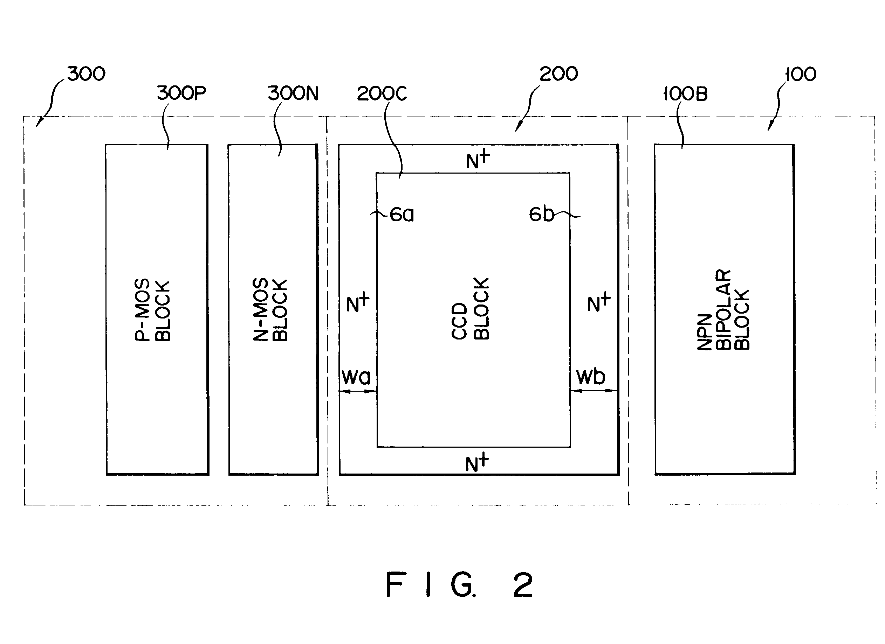

As shown in Fig. 2, in the semiconductor device, manufactured by the above method, including the charge transfer device, the CCD (charge transfer device) block 200C is surrounded by N⁺-type regions 6a and 6b. If the potential of the N⁺-type regions 6a and 6b is biased to a suitable value (e.g. 0 V to 5 V), the charge of the transfer clock, leaked from the charge transfer device is absorbed into the N⁺-type regions 6a and 6b. (When charge is leaked from the CCD block 200C to the bipolar block 100B, leaked charge is absorbed mainly to the wall of the N⁺-type region 6b.) Thus, the charge transfer device and the bipolar transistor can be formed on a single chip, without lowering the reliability of the product. Accordingly, a sample/hold circuit and/or an operational amplifier such as an output circuit, which has conventionally been constituted by MOSFETs, can practically be constituted by bipolar transistors. Thus, the output linearity of the operational amplifier can be improved. In particular, even if a power source voltage of a bipolar operational amplifier is set to 5 V, the linearity of the bipolar operational amplifier is not degraded, and the yield at the time of a wafer test increases (deterioration of linearity is very rare).

When the power source voltage is 5 V, the yield is improved as follows: in the case of a conventional sample/hold circuit or an operational amplifier such as an output circuit constituted by MOSFETs, the yield is about 70 %; whereas in the case of such a circuit or amplifier constituted by bipolar transistors, the yield rises to about 90 %. Furthermore, the use of the power source of 5 V realizes the reduction in consumed power, and the uniformity of power source voltage with other circuit parts. A bipolar IC for processing signals for a charge transfer device, which is conventionally formed in a separate chip, can be formed on the same single chip. A circuit board using the device of the present invention allows a decrease in space, a decrease in manufacturing cost, an increase in number of functions, and simplification of the whole system. In addition, since wiring is not required for connecting separate chips, the yield increases and accordingly the reliability also increases.

In the structure shown in Fig. 2, the influence of clock leak from the CCD block 200C is much greater in the bipolar block 100B than in the MOS block 300N. Supposing that the thicknesses of N⁺-type walls 6a and 6b for shielding clock leak are denoted by Wa and Wb, if Wa + Wb is constant, it is desirable that Wb > Wa.

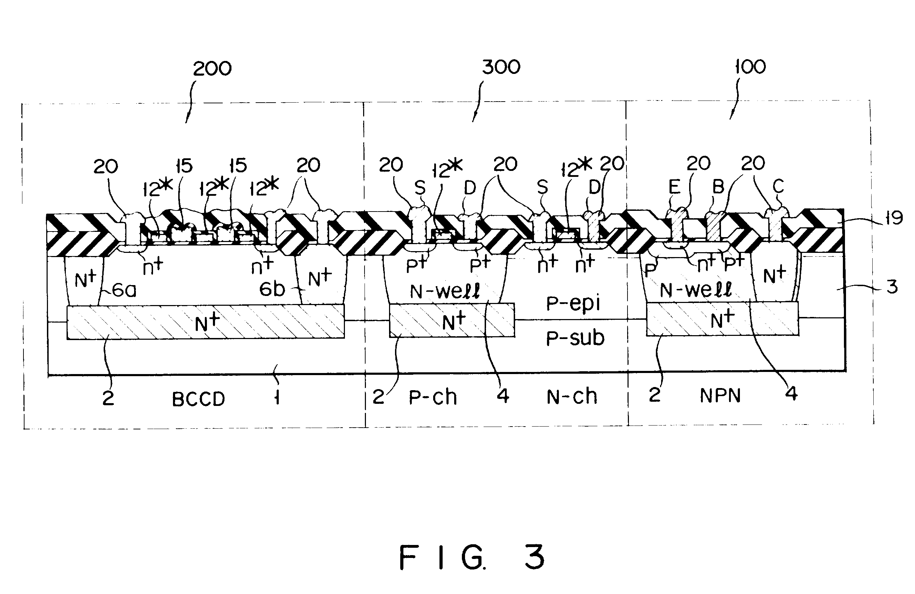

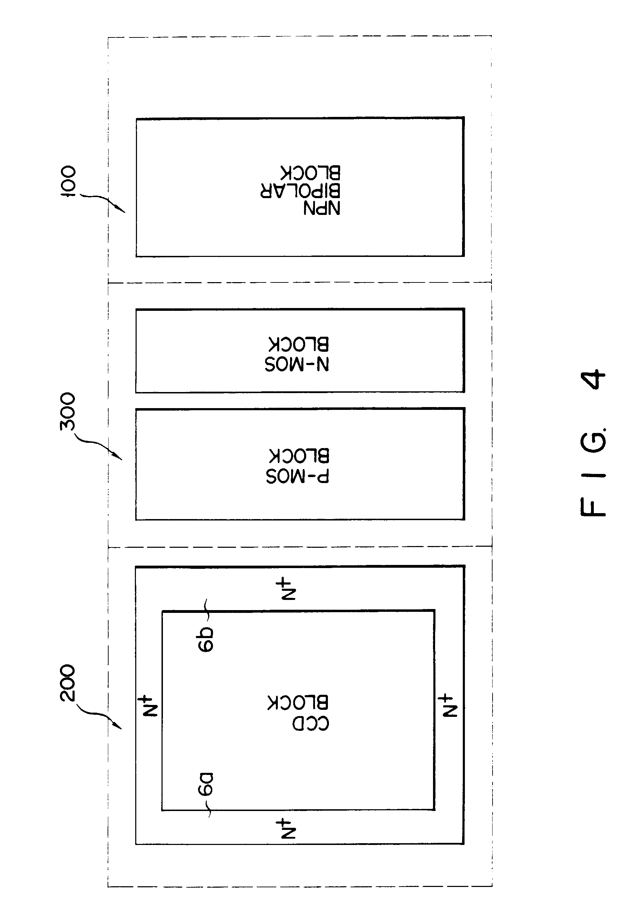

Fig. 3 shows a modification of the structure shown in Fig. 1N, and Fig. 4 shows a modification of the structure shown in Fig. 2. In the modifications shown in Figs. 3 and 4, the MOS transistor block 300, which is less influenced by clock leak than the bipolar transistor block 100, is interposed between the CCD block 200 and the bipolar transistor block 100. Since a large distance can be kept between the CCD block 200 and the bipolar transistor block 100, the thickness of the N⁺-type wall necessary for suppressing clock leak to the bipolar transistor block 100 can be smaller than in the structures shown in Figs. 1N and 2. If the thickness of the N⁺-type wall is reduced, the integration density of the IC can be increased.

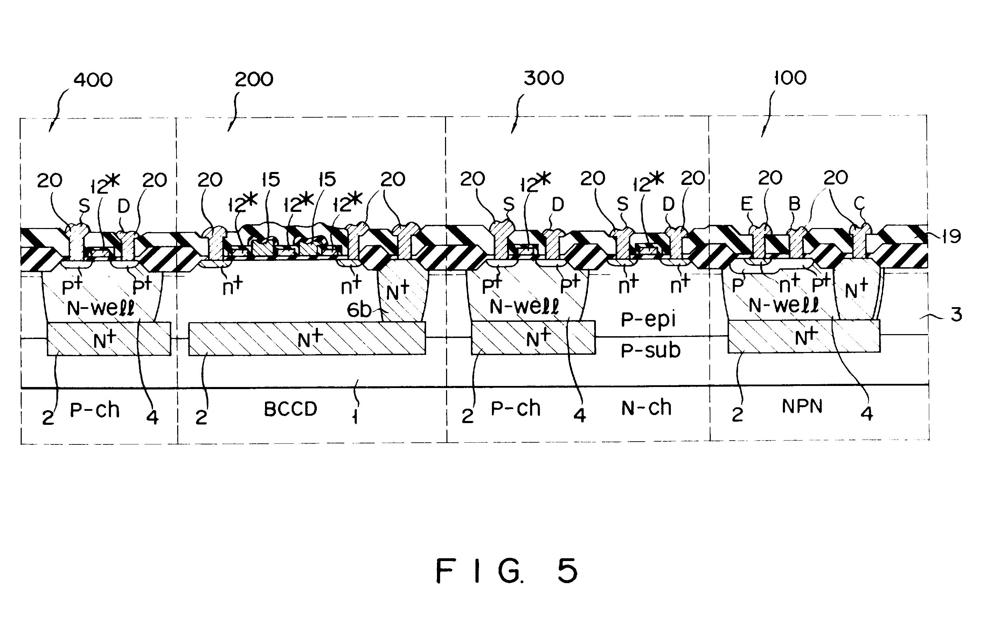

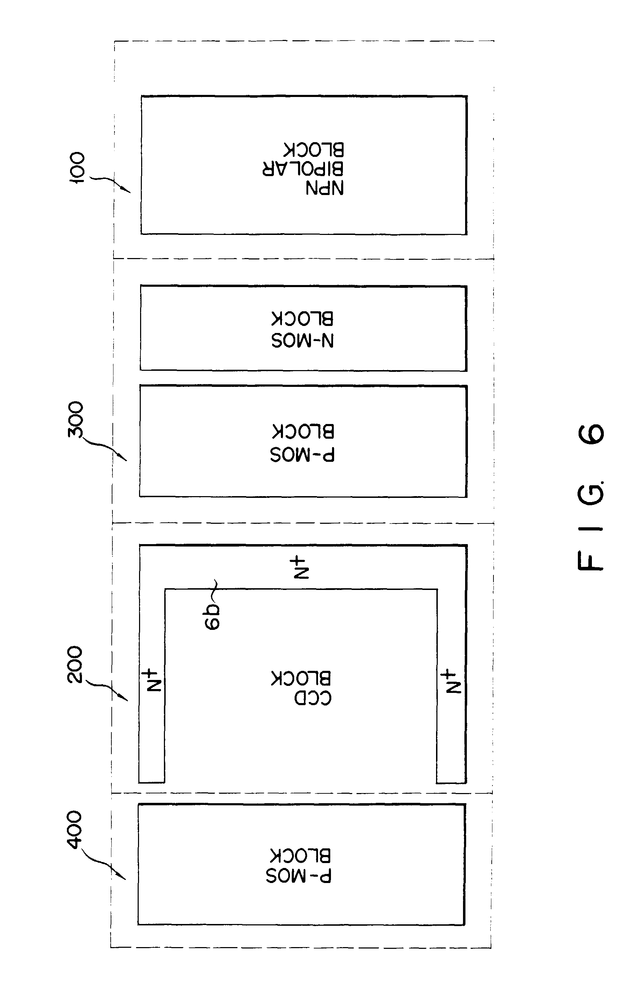

Figures 5 and 6 show an embodiment of the present invention. Fig. 5 is a modification of the structure shown in Fig. 3, and Fig. 6 is a modification of the structure shown in Fig. 4. In the modifications shown in Figs. 5 and 6, the P-MOS transistor block 300 is arranged to face the bipolar transistor block 100. Since the P-MOS transistor block is not easily influenced by the clock leak from the CCD block 200, the N⁺-type wall provided between a P-MOS transistor block 400 and the CCD block 200 is removed to increase the IC integration density.

In the above embodiment, the present invention can be put into practice, even if the semiconductor conductivity types N and P are interchanged.

As has been described above, according to the present invention, a charge transfer device and a bipolar transistor can be formed on a single chip, without lowering the reliability of the finished device. Thus, if a linear amplifier in a semiconductor device including a charge transfer device is constituted by bipolar transistors, the linearity of the linear amplifier is improved, the yield of products is enhanced, and the high-performance of the device is attained.

Furthermore, in the semiconductor device including the charge transfer device and the method of manufacturing the same, according to the present invention, if a bipolar IC for processing signals for the charge transfer device is formed on the same chip, the number of functions of the semiconductor device including the charge transfer device is increased, and the whole system is simplified.

Therefore, the semiconductor device and the manufacturing method thereof, according to the invention, are suitable for apparatuses using CCDs, such as a signal processing system in a VTR, a TV system, a movie camera, etc.

Reference signs in the claims are intended for better understanding and shall not limit the scope.

## Claims

1. Semiconductor device comprising:
a) a semiconductor chip (1, 3),
b) a charge transfer device section (200) formed in said semiconductor chip (1, 3) and driven by predetermined clocks,
c) a bipolar transistor section (100) formed adjacent to said charge transfer device section (200) in said semiconductor chip (1, 3),
d) a prevention means (2, 6b) for preventing charge which is generated in said semiconductor chip (1, 3) owing to said clocks of said charge transfer device section (200) from being transferred to said bipolar transistor section (100), and
e) a first MOS transistor section (300),
***characterized in that***
f) said first MOS transistor section (300) is provided between said charge transfer device section (200) and said bipolar transistor section (100),
g) a second MOS transistor section (400) is provided adjacent to said charge transfer device section (200) at a side thereof lying opposite to said first MOS transistor section (300), and
h) said prevention means (2, 6b) is formed in said semiconductor chip (1, 3) adjacent to said first MOS transistor section (300) and comprises wall regions, without a wall region adjacent to said second MOS transistor section (400).

2. Semiconductor device according to claim 1, characterized in that said second MOS transistor section (400) is provided adjacent to said charge transfer device section (200) in said semiconductor chip (1, 3), said charge transfer section (200) being arranged between said second MOS transistor section (400) and said MOS transistor section (300).

3. Semiconductor device according to claim 1 or 2, characterized in that said prevention means (2, 6b) is formed by a N-type region.

4. Method of manufacturing a semiconductor device including a charge transfer device, comprising the steps of:
a) forming N+-type buried layers (2) in a charge transfer device formation section (200), an NPN-type bipolar transistor section (100), a first P-channel type MOSFET formation section (300), and a second P-channel type MOSFET formation section (400) on a P-type semiconductor substrate (1),
b) forming a P-type epitaxial layer (3) on said P-type semiconductor substrate (1) in which said N+-type buried layers (2) have been formed,
c) forming at least three N-type well regions (4) in said P-type epitaxial layer (3) such that said N-type well regions (4) reach said N+-type buried layers (2) formed in said NPN-type bipolar transistor formation section (100), said first P-channel type MOSFET formation section (300), and said second P-channel type MOSFET formation section (400),
d) forming an N+-type region in said N-type well region (4) of said NPN-type bipolar transistor formation section (100) reaching said N-type buried layer (2) and forming a second N+-type region (6b) in said P-type epitaxial layer (3) of said charge transfer device formation section (200) so that said second N+-type region (6b) constitute wall regions of a charge transfer prevention means (2, 6b) lying adjacent to said first P-channel type MOSFET formation section (300) without a wall region adjacent to said second P-channel type MOSFET formation section (400), and
e) forming an NPN-type bipolar transistor block and a P-channel type MOSFET block in said N-type well regions (4) of said NPN-type bipolar transistor section (100) and said first P-channel type MOSFET formation section (300), respectively, forming a N-channel type MOSFET block in said P-type epitaxial layer (3) of said first P-channel type MOSFET formation section (300), and forming a charge transfer device block in a region of said charge transfer device formation section (200) in said P-type epitaxial layer (3) being partly surrounded by said charge transfer prevention means (2, 6b).

## Patentansprüche

1. Halbleitereinrichtung, enthaltend:
a) einen Halbleiterchip (1, 3),
b) einen Abschnitt für eine Ladungsübertragungseinrichtung (200), der in dem Halbleiterchip (1, 3) gebildet ist und durch festgelegte Taktsignale getrieben wird,
c) einen Bipolartransistorabschnitt (100), der benachbart zu dem Abschnitt für die Ladungsübertragungseinrichtung (200) in dem Halbleiterchip (1, 3) gebildet ist,
d) eine Sperrvorrichtung (2, 6b) zum Vermeiden der Übertragung von Ladung, die in dem Halbleiterchip (1, 3) aufgrund der Taktsignale des Abschnitts für die Ladungsübertragungseinrichtung (200) erzeugt wird, und zwar zu den Bipolartransistorabschnitten (100), und
e) einen ersten MOS-Transistorabschnitt (300),
dadurch **gekennzeichnet**, daß
f) der erste MOS-Transistorabschnitt (300) zwischen dem Abschnitt für die Ladungsübertragungseinrichtung (200) und dem Bipolartransistorabschnitt (100) vorgesehen ist,
g) ein zweiter MOS-Transistorabschnitt (400) benachbart zu dem Abschnitt für die Ladungsübertragungseinrichtung (200) vorgesehen ist, bei einer Seite hiervon, die entgegengesetzt zu dem ersten MOS-Transistorabschnitt (300) liegt, und
h) die Sperrvorrichtung (2, 6b) in dem Halbleiterchip (1, 3) benachbart zu dem ersten MOS-Transistorabschnitt (300) gebildet ist und Wandgebiete enthält, ohne daß ein Wandgebiet benachbart zu dem zweiten MOS-Transistorabschnitt (400) vorgesehen ist.

2. Halbleitereinrichtung nach Anspruch 1, dadurch gekennzeichnet, daß der zweite MOS-Transistorabschnitt (400) benachbart zu dem Abschnitt für die Ladungsübertragungseinrichtung (200) bei dem Halbleiterchip (1, 3) vorgesehen ist, derart, daß der Ladungsübertragungsabschnitt (200) zwischen dem zweiten MOS-Transistorabschnitt (400) und dem MOS-Transistorabschnitt (300) vorgesehen ist.

3. Halbleitereinrichtung nach Anspruch 1 oder 2, dadurch gekennzeichnet, daß die Sperrvorrichtung (2, 6b) durch ein Gebiet vom N-Typ gebildet ist.

4. Verfahren zum Herstellen einer Halbleitereinrichtung mit einer Ladungsübertragungseinrichtung, enthaltend die Schritte:
a) Bilden vergrabener Schichten vom N+-Typ (2) in einem Bildungsabschnitt für eine Ladungsübertragungseinrichtung (200), sowie in einem Abschnitt eines Bipolartransistors vom NPN-Typ (100), einem Bildungsabschnitt für einen ersten MOSFET-Transistor vom P-Kanaltyp (300) und einem Bildungsabschnitt eines zweiten MOSFET-Transistors vom P-Kanaltyp (400) auf einem Halbleitersubstrat vom P-Typ (1),
b) Bilden einer Epitaxialschicht vom P-Typ (3) auf dem Halbleitersubstrat vom P-Typ (1), in dem die vergrabenen Schichten vom N+-Typ (2) gebildet sind,
c) Bilden von zumindest drei Wandgebieten vom N-Typ (4) in der Epitaxialschicht vom P-Typ (3), derart, daß die Wandgebiete vom N-Typ (4) die vergrabenen Schichten vom N+-Typ (2) erreichen, die in dem Bildungsabschnitt für den Bipolartransistor vom NPN-Typ (100) gebildet sind, sowie dem Bildungsabschnitt für den ersten MOSFET-Transistor vom P-Kanaltyp (300) und den Bildungsabschnitt für den zweiten MOSFET-Transistor vom P-Kanaltyp (400),
d) Bilden eines Gebiets vom N+-Typ in dem Wandgebiet vom N-Typ (4) des Bildungsabschnitts für den Bipolartransistor vom NPN-Typ (100), der die vergrabene Schicht vom N-Typ (2) erreicht, und Bilden eines zweiten Gebiets vom N+-Typ (6b) in der Epitaxialschicht vom P-Typ (3) des Bildungsabschnitts für die Ladungsübertragungseinrichtung (200) derart, daß das zweite Gebiet vom N+-Typ (6b) Wandgebiete einer Ladungsübertragungs-Sperrvorrichtung (2, 6b) bildet, die benachbart zu dem Bildungsabschnitt des ersten MOSFET-Transistors vom P-Kanaltyp (300) liegen, ohne ein Wandgebiet benachbart zu dem zweiten Bildungsgebiet des MOSFET-Transistors vom P-Kanaltyp (400), und
e) Bilden eines Bipolartransistorblocks vom NPN-Typ und eines P-Kanaltyp-MOSFET-Blocks in den Randgebieten vom N-Typ (4), jeweils des NPN-Typ-Bipolartransistorabschnitts (100) und des P-Kanaltyp-MOSFET-Bildungsabschnitts (300), Bilden eines N-Kanaltyp-MOSFET-Blocks in der Epitaxialschicht vom P-Typ (3) des ersten P-Kanaltyp-MOSFET-Bildungsabschnitts (300) und Bilden eines Ladungsübertragungseinrichtungs-Blocks in einem Gebiet des Bildungsabschnitts für die Ladungsübertragungseinrichtung (200) in der Epitaxialschicht vom P-Typ (3), das teilweise von der Ladungsübertragungssperrvorrichtung (2, 6b) umgeben ist.

## Revendications

1. Dispositif à semiconducteur comprenant :
a) une puce semiconductrice (1, 3) ;
b) une section de dispositif de transfert de charge (200) formée dans ladite puce semiconductrice (1, 3) et pilotée par des horloges prédéterminées ;
c) une section de transistor bipolaire (100) formée de manière à être adjacente à ladite section de dispositif de transfert de charge (200) dans ladite puce semiconductrice (1, 3) ;
d) un moyen d'empêchement (2, 6b) pour empêcher qu'une charge qui est générée dans ladite puce semiconductrice (1, 3) du fait desdites horloges de ladite section de dispositif de transfert de charge (200) ne soit transférée sur ladite section de transistor bipolaire (100) ; et
e) une première section de transistor MOS (300),
caractérisé en ce que :
f) ladite première section de transistor MOS (300) est prévue entre ladite section de dispositif de transfert de charge (200) et ladite section de transistor bipolaire (100) ;
g) une seconde section de transistor MOS (400) est prévue de manière à être adjacente à ladite section de dispositif de transfert de charge (200) au niveau d'un côté afférent situé à l'opposé de ladite première section de transistor MOS (300) ; et
h) ledit moyen d'empêchement (2, 6b) est formé dans ladite puce semiconductrice (1, 3) de manière à être adjacent à ladite première section de transistor MOS (300) et il comprend des régions de paroi qui ne comprennent pas de région de paroi s'étendant de façon adjacente à ladite seconde section de transistor MOS (400).

2. Dispositif à semiconducteur selon la revendication 1, caractérisé en ce que ladite seconde section de transistor MOS (400) est prévue de manière à être adjacente à ladite section de dispositif de transfert de charge (200) dans ladite puce semiconductrice (1, 3), ladite, section de transfert de charge (200) étant agencée entre ladite seconde section de transistor MOS (400) et ladite section de transistor MOS (300).

3. Dispositif à semiconducteur selon la revendication 1 ou 2, caractérisé en ce que ledit moyen d'empêchement (2, 6b) est formé par une région de type N.

4. Procédé de fabrication d'un dispositif à semiconducteur incluant un dispositif de transfert de charge, comprenant les étapes de :
a) formation de couches enterrées de type N⁺ (2) dans une section de formation de dispositif de transfert de charge (200), dans une section de transistor bipolaire de type NPN (100), dans une première section de formation de MOSFET du type à canal P (300) et dans une seconde section de formation de MOSFET du type à canal P (400) sur un substrat semiconducteur de type P (1);
b) formation d'une couche épitaxiale de type P (3) sur ledit substrat semiconducteur de type P (1) dans lequel lesdites couches enterrées de type N⁺ (2) ont été formées ;
c) formation d'au moins trois régions de puits de type N (4) dans ladite couche épitaxiale de type P (3) de telle sorte que lesdites régions de puits de type N (4) atteignent lesdites couches enterrées de type N⁺ (2) formées dans ladite section de formation de transistor bipolaire de type NPN (100), dans ladite première section de formation de MOSFET de type P (300) et dans ladite seconde section de formation de MOSFET de type à canal P (400) ;
d) formation d'une région de type N+ dans ladite région de puits de type N (4) de ladite section de formation de transistor bipolaire de type NPN (100) atteignant ladite couche enterrée de type N (2) et formation d'une seconde région de type N⁺ (6b) dans ladite couche épitaxiale de type P (3) de ladite section de formation de dispositif de transfert de charge (200) de telle sorte que ladite seconde région de type N⁺ (6b) constitue des régions de paroi d'un moyen d'empêchement de transfert de charge (2, 6b) s'étendant de façon adjacente à ladite première section de formation de MOSFET de type à canal P (300) sans une région de paroi adjacente à ladite seconde section de formation de MOSFET de type à canal P (400); et
e) formation d'un bloc de transistor bipolaire de type NPN et d'un bloc de MOSFET du type à canal P respectivement dans lesdites régions de puits de type N (4) de ladite section de transistor bipolaire de type NPN (100) et dans ladite première section de formation de MOSFET de type à canal P (300), formation d'un bloc de MOSFET du type à canal N dans ladite couche épitaxiale de type P (3) de ladite première section de formation de MOSFET du type à canal P (300) et formation d'un bloc de dispositif de transfert de charge dans une région de ladite section de formation de dispositif de transfert de charge (200) dans ladite couche épitaxiale de type P (3) qui est partiellement entouré par ledit moyen d'empêchement de transfert de charge (2, 6b).
